# EUROPEAN PATENT APPLICATION

(11) **EP 2 551 924 A1**
(43) Date of publication of application: **30.01.2013**
(21) Application number: 11759295.6
(22) Date of filing: 17.03.2011
(51) Int. Cl.: H01L 33/32

(54) **METHOD OF MANUFACTURE FOR LIGHT-EMITTING ELEMENT AND LIGHT-EMITTING ELEMENT MANUFACTURED THEREBY**

(30) Priority: 24.03.2010 JP 2010067959
(71) Applicant: Sumitomo Bakelite Company Limited, Shinagawa-ku Tokyo 140-0002 (JP)
(72) Inventor: KUSUNOKI Junya, Tokyo 140-0002 (JP); TAKEUCHI Etsu, Tokyo 140-0002 (JP); SUGIYAMA Hiromichi, Tokyo 140-0002 (JP); KUBOYAMA Toshiharu, Tokyo 140-0002 (JP); KAWATA Masakazu, Tokyo 140-0002 (JP)
(74) Representative: Ilgart, Jean-Christophe
(86) International application number: PCT/JP2011/056355
(87) International publication number: WO 2011/118489

(57) **Abstract**

An object of the invention is to provide a method of manufacturing a light-emitting element, in which residue from a fixing resin layer is less likely to be left on a semiconductor layer and a supporting base in the case of manufacturing the light-emitting element by a laser lift-off technique. Furthermore, another object of the invention is to provide a highly reliable light-emitting element that is manufactured by the method of the present invention. The above-described objects are accomplished by applying a thermally decomposable resin composition as a fixing resin layer that fixes the semiconductor layer to a supporting base, and by thermally decomposing the fixing resin layer at the time of peeling off the semiconductor layer from the supporting base.

## Description

### TECHNICAL FIELD

The present invention relates to a method of manufacturing a light-emitting element and a light-emitting element manufactured by the method.

Priority is claimed on Japanese Patent Application No. 2010-067959, filed March 24, 2010, the content of which is incorporated herein by reference.

### BACKGROUND ART

In recent years, light-emitting elements including a compound semiconductor layer having a semiconductor layer and a light-emitting layer have come into practical use and have been used for illumination devices or the like. As these light-emitting devices, group III nitride semiconductors such as blue light-emitting elements and ultraviolet light-emitting elements may be mentioned.

Group III nitride semiconductors are excellent in light-emitting efficiency in a wide range from visible light to ultraviolet light compared to group III-V compound semiconductors in the related art. Furthermore, in addition to this, group III nitride semiconductors are also excellent in other semiconductor characteristics, and are expected to be widely used in the LED field in the future.

Group III nitride semiconductors are produced on substrates by a metalorganic chemical vapor deposition (MOCVD) method, but due to a problem of a lattice matching property, only sapphire glass is put into practical use as each of the substrates. In light-emitting elements of a face-up or flip-chip type in which sapphire glass is used as the substrate in the related art, there is a problem in that since sapphire glass is very hard, advanced technology is necessary to divide the substrate into individual pieces, or since the sapphire glass has poor thermal conductivity, a heat dissipation property, which is generated in a group III nitride semiconductor layer, is poor.

In consideration of the above-described problem, a method in which the group III nitride semiconductor layer that is formed on the sapphire glass is fixed to a supporting base through a fixing layer, and the sapphire glass is peeled off by a laser lift-off technique is disclosed (Patent Document 1). In this method, when peeling off the group III nitride semiconductor layer from the supporting base, since residue from the fixing layer remains on the group III nitride semiconductor layer or the supporting base, a cleaning process is necessary to remove the residue.

### Citation List

### Patent Document

[Patent Document 1] Japanese Unexamined Patent Application, First Publication No. 2009-54693

### SUMMARY OF INVENTION

### Technical problem

An object of the invention is to provide a method of manufacturing a light-emitting element, in which residue from a fixing resin layer is less likely to be left on a group III nitride semiconductor layer and a supporting base in the case of manufacturing the light-emitting element by a laser lift-off technique. Furthermore, another object of the invention is to provide a highly reliable light-emitting element that is manufactured by the method of the present invention.

### Solution to problem

The above-described objects may be achieved by techniques described in the following (1) to (9).
(1) A method of manufacturing a light-emitting element including: a first process of forming a compound semiconductor layer including semiconductor layers and a light-emitting layer on a growth substrate; a second process of forming an electrode on the compound semiconductor layer; a third process of adhering a thermally decomposable fixing resin layer of a thermally decomposable fixing resin layer-attached supporting base in which the thermally decomposable fixing resin layer is formed on the supporting base, and the compound semiconductor layer; a fourth process of irradiating a surface of the growth substrate, which is opposite to a surface on which the compound semiconductor layer is formed, with laser light so as to peel the growth substrate and the compound semiconductor layer away from each other; a fifth process of thermally decomposing the thermally decomposable fixing resin layer so as to peel the compound semiconductor layer from the supporting base away; and a sixth process of dividing the compound semiconductor layer into individual pieces.
(2) The method according to (1), wherein the semiconductor layers may be an n-type semiconductor layer and a p-type semiconductor layer.
(3) The method according to (1) or (2), wherein the growth substrate may be made of sapphire glass.
(4) The method according to any one of (1) to (3), wherein a temperature to thermally decompose the thermally decomposable fixing resin layer in the fifth process may be 50 to 500°C.
(5) The method according to any one of (1) to (4), wherein the thermally decomposable fixing resin layer may contain at least one thermally decomposable resin component selected from a group consisting of a polycarbonate-based resin, a polyester-based resin, a polyamide-based resin, a polyimide-based resin, a polyether-based resin, a polyurethane-based resin, and a norbomene-based resin.
(6) The method according to any one of (1) to (5), wherein the thermally decomposable resin component may be a polycarbonate-based resin.
(7) The method according to any one of (1) to (6), wherein the thermally decomposable fixing resin layer may contain a photoacid generator.
(8) The method according to any one of (5) to (7), wherein the polycarbonate-based resin may include at least one kind of structure unit selected from a group consisting of propylene carbonate, cyclohexylene carbonate, butylene carbonate, and norbomane carbonate.
(9) A light-emitting element manufactured by the method according to any one of (1) to (8).

### Advantageous effects of invention

According to the present invention, it is possible to provide a method of manufacturing a light-emitting element, in which residue from a fixing resin layer is less likely to be left on a group III nitride semiconductor layer and a supporting base in the case of manufacturing the light-emitting element by a laser lift-off technique. Furthermore, according to the present invention, it is possible to provide a highly reliable light-emitting element.

### BRIEF DESCRIPTION OF DRAWINGS

FIG. 1 is a schematic longitudinal cross-sectional view illustrating an embodiment of a light-emitting element of the present invention.
FIG. 2 is a schematic longitudinal cross-sectional view illustrating an embodiment of the light-emitting element of the present invention.
FIG. 3 is a schematic longitudinal cross-sectional view illustrating an example of a method of manufacturing the light-emitting element of the present invention.
FIG. 4 is a schematic longitudinal cross-sectional view illustrating the example of the method of manufacturing the light-emitting element of the present invention.
FIG. 5 is a schematic longitudinal cross-sectional view illustrating the example of the method of manufacturing the light-emitting element of the present invention.

### DESCRIPTION OF EMBODIMENTS

Hereinafter, a method of manufacturing a light-emitting element of the present invention and the light-emitting element of the present invention will be described in detail besed on an appropriate embodiment shown in the attached drawings.

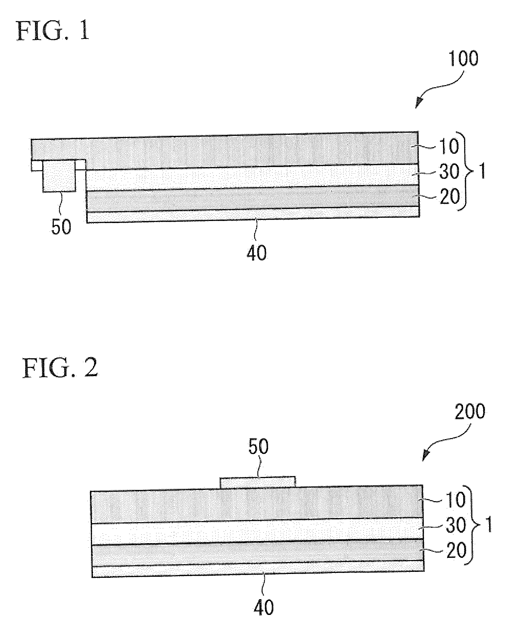

FIGS. 1 and 2 are longitudinal cross-sectional views illustrating an example of a light-emitting element that is manufactured by the method of manufacturing light-emitting elements of the present invention. In addition, in the following description, an upper side and a lower side in FIGS. 1 and 2 are referred to as "over" and "under", respectively.

A light-emitting element 100 shown in FIG. 1 includes a compound semiconductor layer 1 in which a p-type semiconductor layer 20, a light-emitting layer 30, and an n-type semiconductor layer 10 are laminated in this order. An n-type electrode 50 and a p-type electrode 40 are formed under the n-type semiconductor layer 10 and the p-type semiconductor layer 20, respectively.

A light-emitting element 200 shown in FIG. 2 includes the compound semiconductor layer 1 in which the p-type semiconductor layer 20, the light-emitting layer 30, and the n-type semiconductor layer 10 are laminated in this order. The n-type electrode 50 and the p-type electrode 40 are formed over the n-type semiconductor layer 10 and under the p-type semiconductor layer 20, respectively.

The n-type semiconductor layer 10 and the p-type semiconductor layer 20 are not particularly limited, but a known semiconductor material such as a GaN-based single crystal, a GaP-based single crystal, or a GaAs-based single crystal may be used as a material thereof. Among these, it is preferable to use the GaN-based single crystal that may easily grow in an epitaxial growth manner on a surface of a growth substrate (a sapphire glass substrate or the like).

A material that is used for the light-emitting layer 30 is not particularly limited, but examples thereof include a GaN-based semiconductor such as In_{S}Ga₁₋ₛN (0<S<0.3). In addition, the light-emitting layer 30 includes a quantum well layer including a barrier layer in which a bandgap is wide and a well layer in which the bandgap is narrow. The quantum well layer may be any one of a single quantum well layer (SQW) or a multiple quantum well layer (MQW).

The thickness of the barrier layer is not particularly limited, but approximately 5 to 15 nm is preferable. In addition, it is preferable that the thickness of the well layer be approximately 2 to 100 nm. Furthermore, the total thickness of the light-emitting layer 30 is not particularly limited, but approximately 25 to 150 nm is preferable.

The material that is used in the p-type electrode 40 is not particularly limited, but examples thereof include elemental copper , a copper-tungsten alloy, and the like. Among these, the elemental copper, which is excellent in thermal conductivity, is preferable. In addition, the p-type electrode 40 may include a seed layer and a barrier layer. As a material that is used for the seed layer, a metal such as titanium may be mentioned, and as a material that is used for the barrier layer, a metal such as tantalum may be mentioned.

The n-type electrode 50 is not particularly limited, but a thin film formed by laminating chrome, aluminum, titanium, or gold may be used for the n-type electrode 50, and the n-type electrode 50 may be formed by a known sputtering method or deposition method.

A light-emitting element 100 shown in FIG. 1 may be manufactured, for example, as described below.

### Manufacturing of Light-Emitting Element:

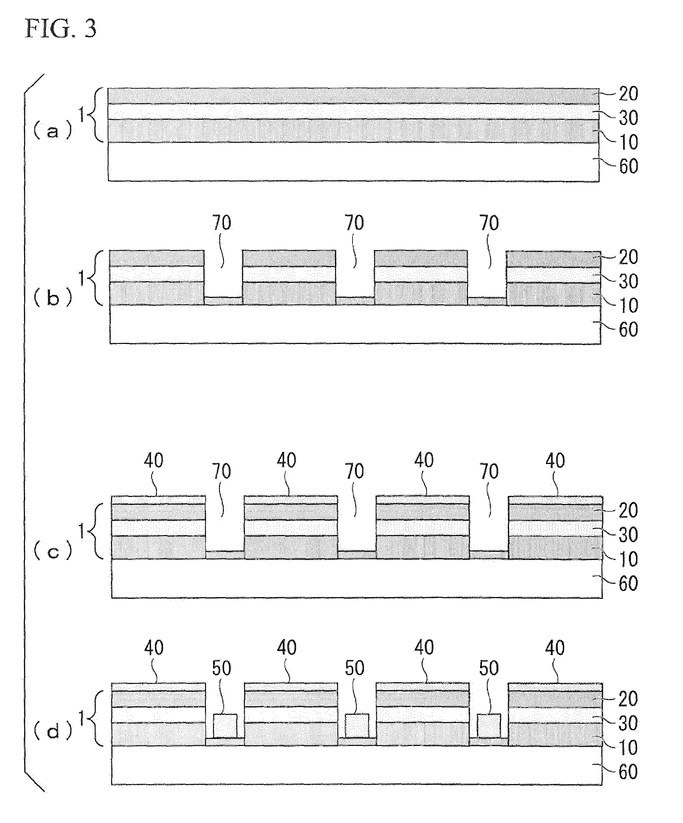

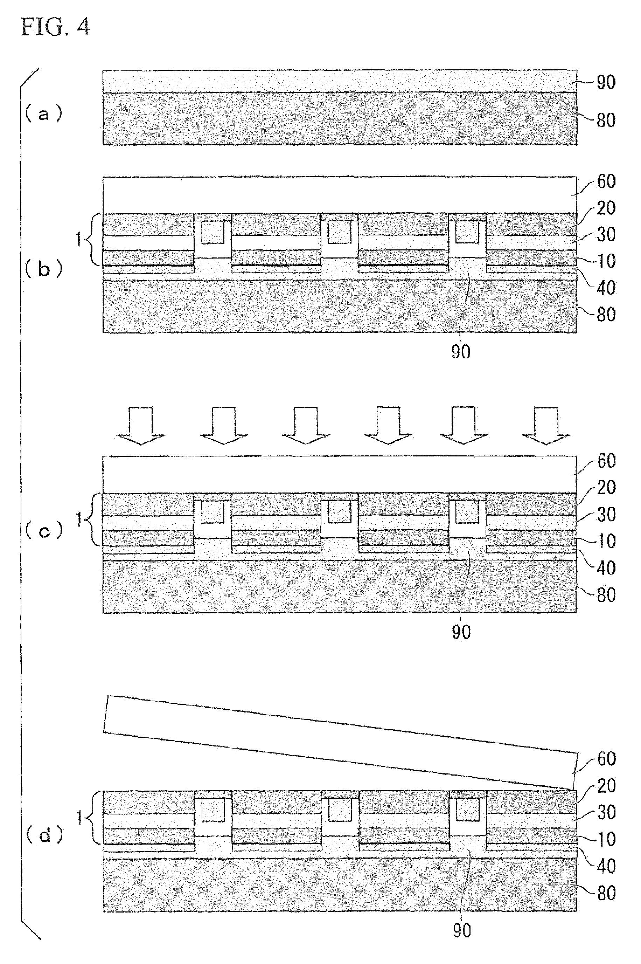

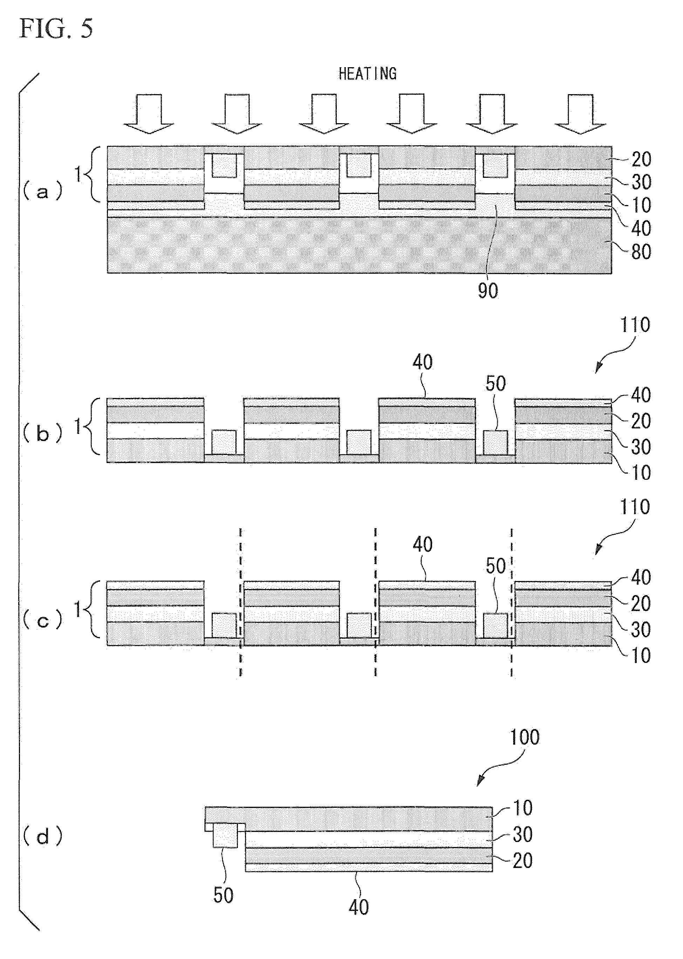

Hereinafter, a first embodiment of a method of manufacturing a light-emitting element to obtain the light-emitting element 100 will be described with reference to FIGS. 3 to 5. In addition, an upper side and a lower side in FIGS. 3 to 5 are referred to as "over" and "under", respectively.

### First Embodiment:

### First Process

(A-1) First, as shown in FIG. (3-a), the compound semiconductor layer 1 is formed by laminating the n-type semiconductor layer 10, the light-emitting layer 30, and the p-type semiconductor layer 20 on a growth substrate 60 in this order.

At this time, since the substrate 60 and the n-type semiconductor layer 10 are significantly different in a lattice constant, it is preferable to form a buffer layer, which has an intermediate lattice constant between those of the substrate 60 and the n-type semiconductor layer 10, on the substrate 60 in advance. Due to this, the crystallinity of the n-type semiconductor layer may be improved. A material that is used for the buffer layer is not particularly limited, but in a case where a sapphire glass substrate is used as the substrate, AlN or AlGaN may be mentioned as the material.

A method of forming the n-type semiconductor layer 10, the light-emitting layer 30, and the p-type semiconductor layer 20 is not particularly limited, and examples thereof include a sputtering method, MOCVD (metalorganic chemical vapor deposition method), MBE (molecular beam epitaxy method), HVPE (hydride vapor phase epitaxy method), and the like, but MOCVD, which is capable of easily controlling the film thickness, is preferable.

The growth substrate 60 is not particularly limited, and examples thereof include a sapphire glass substrate, a GaAs substrate, a silicon substrate, and the like, but sapphire glass substrate, which is capable of easily growing a semiconductor layer in an epitaxial growth manner, is preferable.

(B-1) Next, as shown in FIG. (3-b), grooves 70 are formed in the compound semiconductor layer 1 so as to partition each light-emitting element.

A method of forming the grooves 70 is not particularly limited, but the forming of the grooves 70 may be carried out by applying a common photography technology such as etching.

### Second Process

(C-1) Next, as shown in FIG. (3-c), the p-type electrode 40 is formed on the p-type semiconductor layer 20.

The p-type electrode 40 is not particularly limited, but it is preferable that the p-type electrode 40 be provided with an ohmic contact layer and a reflecting layer. When the p-type electrode 40 is provided with the reflecting layer, light emitted from a light emitting layer 30 may be reflected to a light taking-out surface.

When the p-type electrode 40 is provided with the ohmic contact layer, a contact resistance with the p-type semiconductor layer 20 may be lowered. A material that is used for the ohmic contact layer is not particularly limited, but a platinum group such as platinum, ruthenium, osmium, rhodium, iridium, and palladium, or silver is preferable as the material, platinum, iridium, rhodium, and ruthenium are more preferable, and platinum is still more preferable. It is preferable that the thickness of the ohmic contact layer is 0.1 nm or more so as to stably obtain a low contact resistance, and more preferably 1 nm or more. When the thickness of the ohmic contact layer is set to the above-described range, a stable contact resistance with the p-type semiconductor layer 20 may be obtained.

A material that is used for the reflecting layer is not particularly limited, but a gold alloy or a silver alloy that may secure a preferable reflectance is preferable. The thickness of the reflecting layer is preferably 0.1 to 300 nm, and more preferably 1 to 200 nm. When the thickness of the reflecting layer is set to the above-described range, a preferable reflectance and migration resistance may be compatible with each other.

(D-1) Next, as shown in FIG. (3-d), the n-type electrode 50 is formed on the n-type semiconductor layer 10.

The n-type electrode 50 is not particularly limited, but may be formed by laminating a gold layer on an underlying metal layer formed of chrome, titanium, aluminum, or the like. Due to this, ohmic contact between the n-type electrode 50 and the n-type semiconductor layer 10 may be obtained without performing an annealing treatment. Specifically, as a structure of the n-type electrode 50, for example, a three-layer structure of chrome, titanium and gold, and a four-layer structure of titanium, aluminum, titanium, and gold may be mentioned.

### Third Process

(E-1) Next, as shown in FIG. (4-a), a supporting base 80 is prepared, and a thermally decomposable fixing resin layer 90 is formed on the supporting base 80.

The supporting base 80 is not particularly limited, and a substrate having a function of supporting the compound semiconductor layer 1 may be used. As the supporting base 80, for example, glass, quartz, silicon, ceramic, metal, an organic substrate, and the like may be mentioned, but glass and quartz are preferable. This is because glass and quartz have excellent light transmitting properties and thus are capable of effectively lowering a thermal decomposition temperature of the thermally decomposable fixing resin layer 90 by exposing the thermally decomposable fixing resin layer 90.

The thermally decomposable fixing resin layer 90 is not particularly limited, and may be formed from a resin composition that maintains a liquid form at 25°C or a resin composition that maintains a film form at 25°C. In the case of the a resin composition that maintains a liquid form at 25°C, the thermally decomposable fixing resin layer 90 may be formed on the supporting base 80 by dispensing or spin-coating the resin composition onto the supporting base 80. In addition, in the case of the resin composition that maintains a film shape at 25°C, the thermally decomposable fixing resin layer 90 may be formed on the supporting base 80 by laminating the resin composition on the supporting base 80.

### Thermally Decomposable Resin Composition

Here, a thermally decomposable resin composition that makes up the thermally decomposable fixing resin layer 90 will be described.

The thermally decomposable resin composition contains a thermally decomposable resin component as a requisite component, and may contain other resin components such as an activator, a sensitizer, an antioxidant, and a solvent as necessary.

As the thermally decomposable resin component that makes up the thermally decomposable resin composition, a resin component whose 50% weight loss temperature is 50 to 500°C is preferable, and a resin component whose 50% weight loss temperature is 100 to 400°C is more preferable. When the thermal decomposition temperature of the thermally decomposable resin composition is set to the above-described range, a process resistant property and prevention of damage to a light-emitting element may be compatible with each other.

In the present invention, a 5% weight loss temperature, a 50% weight loss temperature, and a 95% weight loss temperature represent temperatures at which weights of 5%, 50%, and 95% are respectively lost when the thermally decomposable resin component is measured by TG/DTA (thermogravimetry/differential thermal analysis).

Here, the TG/DTA measurement may be performed by precisely weighing 10 mg of a resin component and by measuring the resin component using TG/DTA device (manufactured by Seiko Instruments Inc.) (an atmosphere: nitrogen, and a temperature rising rate: 5°C/minute).

The thermally decomposable resin component is not particularly limited, but examples thereof include a polycarbonate-based resin, a polyester-based resin, a polyamide-based resin, a polyimide-based resin, a polyether-based resin, a polyurethane-based resin, a norbomene-based resin, a (meth)acrylate-based resin, a polylactic acid resin, and the like. Among these thermally decomposable resin components, the polycarbonate-based resin, the norbomene-based resin, and the polylactic acid resin are preferable because these resins may effectively prevent thermal decomposition of the thermally decomposable fixing resin layer 90 during a process of manufacturing a light-emitting element, and may effectively shorten a thermal decomposition time of the thermally decomposable fixing resin layer 90 in a fifth process (described later).

In a case where the thermally decomposable resin component is the polycarbonate-based resin, a resin whose decomposition time at the 5% weight loss temperature is 1 to 60 minutes is preferable.

When the decomposition temperature is set to be greater than or equal to the lower limit, rapid thermal decomposition of the thermally decomposable fixing resin layer may be suppressed, and thus thermally decomposed gas may be exhausted by an exhaust device. Therefore, contamination on a light-emitting element or a facility of manufacturing the light-emitting element may be prevented. In addition, when the decomposition temperature is set to be less than or equal to the upper limit, a time that is necessary for the fifth process may be shortened and thus the productivity of the light-emitting element may be improved.

Here, the thermal decomposition time may be measured by the following method.

First, the 5% weight loss temperature is calculated by the above-described method. Then, the measurement is carried out by precisely weighing approximately 10 mg of the thermally decomposable resin component, raising the temperature from 25°C to the 5% weight loss temperature for 30 minutes, and maintaining a measurement temperature at the 5% weight loss temperature using the TG/DTA device. A time at which it reaches the 5% weight loss temperature is set as a starting point (zero minute), and a time at which it reaches the 95% weight loss temperature is set as the decomposition time.

The polycarbonate-based resin is not particularly limited, but examples thereof include propylene carbonate, ethylene carbonate, 1,2-butylene carbonate, 1,3-butylene carbonate, 1,4-butylene carbonate, cis-2,3-butylene carbonate, trans-2,3-butylene carbonate, α,β-isobutylene carbonate, α,γ-isobutylene carbonate, cis-1,2-cyclobutylene carbonate, trans-1,2-cyclobutylene carbonate, cis-1,3-cyclobutylene carbonate, trans-1,3-cyclobutylene carbonate, hexene carbonate, cyclopropene carbonate, cyclohexene carbonate, methylcyclohexene carbonate, vinylcyclohexene carbonate, dihydronaphthalene carbonate, hexahydrostyrene carbonate, cyclohexanepropylene carbonate, styrene carbonate, 3-phenylpropylene carbonate, 3-trimethylsilyloxypropylene carbonate, 3-methacryloyloxypropylene carbonate, perfluoropropylene carbonate, norbornene carbonate, and a polycarbonate-based resin having a skeleton formed of a combination thereof.

More specific examples of the polycarbonate-based resin include a polypropylene carbonate/polycyclohexene carbonate copolymer, poly[(oxycarbonyloxy-1,1,4,4-tetramethylbutane)-alt-(oxycarbonyloxy-5-norborne ne-2-endo-3-endo-dimethane)], poly[(oxycarbonyloxy-1,4-dimethylbutane)-alt-(oxycarbonyloxy-5-norbornene-2-e ndo-3-endo-dimethane)], poly[(oxycarbonyloxy-1,1,4,4-tetramethylbutane)-alt-(oxycarbonyloxy-p-xylene)], poly[(oxycarbonyloxy-1,4-dimethylbutane)-alt-(oxycarbonyloxy-p-xylene)], a polycyclohexene carbonate/polynorbornene carbonate copolymer, poly[(oxycarbonyloxy-5-norbornene-2-endo-3-endo-dimethane)], poly[(oxycarbonyloxy-5-norbornene-2-exo-3-exo-dimethane)], poly[trans-(oxycarbonyloxy-5-norbornene-2,3-dimethane)], a poly(oxycarbonyloxy)-cis-exo-2,3-dimethylnorbornane-2,3-poly(oxycarbonyloxy) -cis-endo-2,3-dimethylnorbornane-2,3-diyl) copolymer, a poly(oxycarbonyloxycyclohexane-1,3,-diyl)-poly(oxycarbonyloxy-cis-exo-2,3-di methylnorbornane-2,3-diyl) copolymer, and a poly(oxycarbonyloxycyclohexane-1,3,-diyl)-poly(oxycarbonyloxy-cis-endo-2,3-dimethylnorbomane-2,3-diyl) copolymer.

A weight-average molecular weight (Mw) of the polycarbonate-based resin is preferably 1,000 to 1,000,000, and more preferably 5,000 to 800,000. When the weight-average molecular weight is set to be greater than or equal to the lower limit, an effect of improving wettability of the thermally decomposable resin composition with respect to the supporting base or the compound semiconductor layer, and an effect of improving a film forming property may be obtained. Furthermore, when the weight-average molecular weight is set to be less than or equal to the upper limit, an effect of increasing compatibility with each resin component making up the thermally decomposable resin composition or solubility with respect to various solvents, and a thermal decomposition property of the thermally decomposable fixing resin layer in the fifth process, may be obtained.

A method of polymerizing the polycarbonate-based resin is not particularly limited, and for example, various known polymerization methods such as a phosgene method (solution method) and an ester exchange method (melting method) may be used.

It is preferable that the thermally decomposable resin component be mixed at a proportion of 10 to 100% based on the total amount of the thermally decomposable resin composition, and more preferably 20 to 100%. When the content of the thermally decomposable resin component is set to be greater than or equal to the lower limit, it is possible to prevent the thermally decomposable fixing resin layer from remaining on the supporting base or in the light-emitting element after the fifth process to be described later.

As the thermally decomposable resin component, polypropylene carbonate polymer, 1,4-polybutylene carbonate polymer, and polycyclohexene carbonate/polynorbornene carbonate copolymer are particularly preferable.

In addition, the thermally decomposable resin composition may contain an activator that generates active species when energy is applied by irradiation of active energy rays. Due to this configuration, the decomposition temperature of the thermally decomposable resin component may be lowered.

The activator is not particularly limited, but examples thereof include a photoacid generator and a photobase generator. The photoacid generator is not particularly limited, but examples thereof include tetrakis(pentafluorophenyl)borate-4-methylphenyl[4-(1-methylethyl)phenyl]iodoni um (DPI-TPFPB), tris(4-t-butylphenyl)sulfonium tetrakis(pentafluorophenyl)borate (TTBPS-TPFPB), tris(4-t-butylphenyl)sulfonium hexafluorophosphate (TTBPS-HFP), triphenylsulfonium triflate (TPS-Tf), bis(4-tert-butylphenyl)iodonium triflate (DTBPI-Tf), triazine (TAZ-101), triphenylsulfonium hexafluoroantimonate (TPS-103), triphenylsulfonium bis(perfluoromethanesulfonyl)imide (TPS-N1), di(p-t-butyl)phenyliodonium, bis(perfluoromethanesulfonyl)imide (DTBPI-N1), triphenylsulfonium, tris(perfluoromethanesulfonyl)methide (TPS-C1), di(p-t-butylphenyl)iodonium tris(perfluoromethanesulfonyl)methide (DTBPI-C1), tris {4-[(4-acetylphenyl)thio]phenyl}sulfonium tris(perfluoromethanesulfonyl)methide, and a combination of two or more thereof

Among these, tetrakis(pentafluorophenyl)borate-4-methylphenyl[4-(1-methylethyl)phenyl]iodoni um (DPI-TPFPB) and tris{4-[(4-acetylphenyl)thio]phenyl}sulfonium tris(perfluoromethanesulfonyl)methide are particularly preferred since the thermal decomposition temperature of the thermally decomposable resin component may be effectively lowered.

The photobase generator is not particularly limited, but examples thereof include 5-benzil-1,5-diazabicyclo [4.3.0] nonane, 1-(2-nitrobenzoyl carbamoyl) imidazole, and the like. Among these components, 5-benzil-1,5-diazabicyclo [4.3.0] nonane and derivatives thereof are particularly preferable from the viewpoint of effectively lowering the thermal decomposition temperature of the thermally decomposable resin component.

It is preferable that the activator be mixed at a proportion of 0.01 to 50% based on the total amount of the thermally decomposable resin composition, and more preferably 0.1 to 30%. When the content of the activator is set to be greater than or equal to the lower limit, the thermal decomposition temperature of the thermally decomposable resin component may be stably lowered, and when the content of the activator is set to be less than or equal to the upper limit, it is possible to effectively prevent the thermally decomposable fixing resin layer from remaining on the supporting base or in the light-emitting element as a residue.

As a particularly preferable combination of the polycarbonate-based resin and the activator, the following combination may be mentioned. Specifically, as the polycarbonate-based resin, polypropylene carbonate polymer, 1,4-polybutylene carbonate polymer, neopentyl carbonate polymer, and cyclohexene carbonate/norbomene carbonate copolymer may be mentioned, and as the activator, tetrakis(pentafluorophenyl)borate-4-methylphenyl[4-(1-methylethyl)phenyl]iodoni um (DPI-TPFPB), tris {4-[(4-acetylpenyl)thio]penyl}sulfoniumtris(perfluoromethanesulphonyl)methi de may be mentioned.

In this case, the thermally decomposable resin component is preferably 20 to 100% based on the total amount of the thermally decomposable resin composition, the activator is preferably 0.1 to 30% based on the total amount of the thermally decomposable resin composition, and a weight-average molecular weight (Mw) of the thermally decomposable resin composition is preferably 5,000 to 800,000. This preference is from the viewpoints of securing wettability with respect to the supporting base or the compound semiconductor layer, a film forming property of the thermally decomposable resin composition, compatibility with each resin component making up the thermally decomposable resin composition or solubility with respect to various solvents, and a thermal decomposition property of the thermally decomposable fixing resin layer in the fifth process.

Since the polycarbonate-based resin forms a structure in which thermal cutting of a main chain of the polycarbonate-based resin becomes easy in the presence of the activator, or forms a thermal cyclization structure in which the polycarbonate-based resin itself is easily thermally decomposed (thermal cyclization reaction), it is considered that the thermal decomposition temperature may be lowered.

The following reaction formula (1) represents a mechanism in which the thermal cyclization structure of the main chain of the polypropylene carbonate resin are formed by thermal cleavage.

First, H⁺ that is derived from the activator protonates carbonyl oxygen of the polypropylene carbonate resin, transitions a polar transition state, and causes unstable tautomeric intermediates [A] and [B] to generate.

Next, in the case of thermal cutting of the main chain, the intermediate [A] fragments into acetone and CO₂.

In the case of the formation of the thermal cyclization structure (a or b), the intermediate [B] forms propylene carbonate, and the propylene carbonate fragments into CO₂ and propylene oxide.

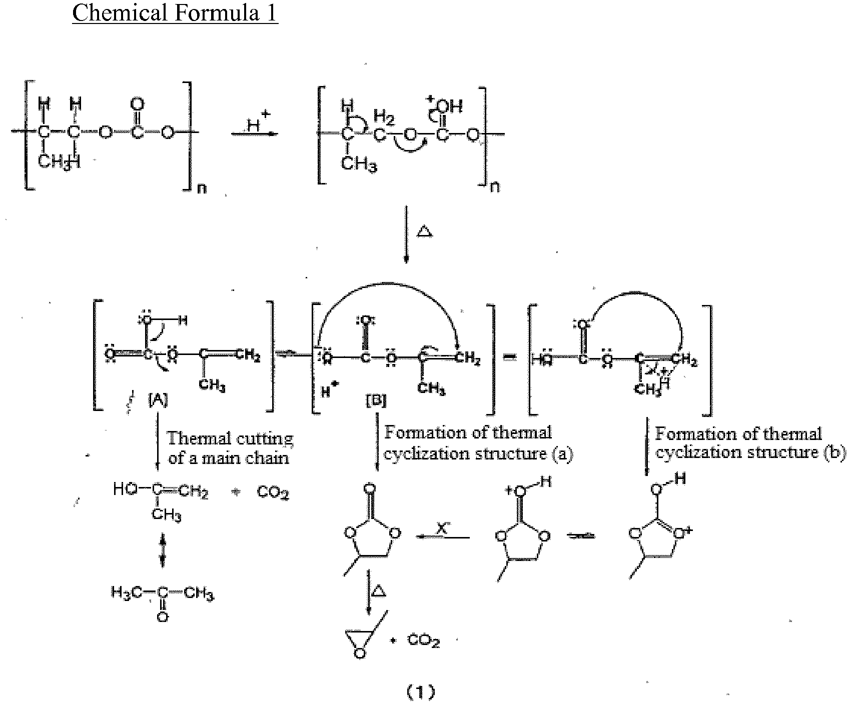

In addition, the thermal decomposable resin composition may contain a solvent. The solvent is not particularly limited, but examples thereof include hydrogen carbons such as mesitylene, decaline, and mineral sprits, alcohols/ethers such as anisole, propylene glycol monomethyl ether, dipropylene glycol methyl ether, diethylene glycol monoethyl ether, and diglyme, esters/lactones such as ethylene carbonate, ethyl acetate, N-butyl acetate, ethyl lactate, ethyl 3-ethoxypropionate, propylene glycol monomethyl ether acetate, diethylene glycol monoethyl ether acetate, propylene carbonate, and γ-butyrolactone, ketones such as cyclopentanone, cyclohexanone, methyl isobutyl ketone, and 2-heptanone, and amides/lactams such as N-methyl-2-pyrrolidinone. When the thermally decomposable resin composition contains a solvent, viscosity of the thermally decomposable resin composition may be easily adjusted, and thus a thin film of the thermally decomposable fixing resin layer may be easily formed on the supporting base.

The content of the solvent is not particularly limited, but 5 to 98% by weight is preferable, and 10 to 95% by weight is more preferable.

The thermally decomposable resin composition may contain a sensitizer that is a component having a function of exhibiting or increasing reactivity of the activator with respect to light of a particular type or wavelength together with the activator.

The sensitizer is not particularly limited, but examples thereof include anthracene, phenanthrene, chrysene, benzpyrene, fluoranthene, rubrene, pyrene, xanthone, indanthrene, thioxanthene-9-on, 2-isopropyl-9H-thioxanthene-9-on, 4-isopropyl-9H-thioxanthene-9-on, 1-chloro-4-propoxy thioxanthone, and a mixture thereof. The content of the sensitizer is preferably less than or equal to 100 parts by weight based on 100 parts by weight of the above-described activator, and more preferably less than or equal to 20 parts by weight.

In addition, the thermally decomposable resin composition may contain an antioxidant. The antioxidant has a function of preventing not-preferable acid from occurring or preventing the resin composition from being naturally oxidized.

The antioxidant is not particularly limited, but for example, Ciba IRGANOX (registered trademark) 1076 or Ciba IRGAFOS (registered trademark) 168 that are available from Ciba Fine Chemicals Company located at Tarrytown, New York may be suitably used.

Furthermore, as other antioxidants, for example, Ciba Irganox (registered trademark) 129, Ciba Irganox 1330, Ciba Irganox 1010, Ciba Cyanox (registered trademark) 1790, Ciba Irganox 3114, Ciba Irganox 3125, and the like may be used.

The content of the antioxidant is preferably 0.1 to 10 parts by weight based on 100 parts by weight of the thermally decomposable resin component, and more preferably 0.5 to 5 parts by weight.

Furthermore, the thermally decomposable resin composition may further contain additives such as an acryl-based, silicone-based, fluorine-based, or vinyl-based leveling agent, a silane coupling agent, and a diluting agent.

The silane coupling agent is not particularly limited, but examples thereof include 3-glycidoxypropyltrimethoxysilane, 3-glycidoxypropylmethyldiethoxysilane, 3-glycidoxypropyltriethoxysilane, p-styryltrimethoxysilane, 3-methacryloxypropylmethyldimethoxysilane, 3-methacryloxypropyltrimethoxysilane, 3-methacryloxypropylmethyldiethoxysilane, 3-methacryloxypropyltriethoxysilane, 3-acryloxypropyltrimethoxysilane, N-2-(aminoethyl)-3-aminopropylmethyldimethoxysilane, N-2-(aminoethyl)-3-aminopropyltrimethoxysilane, N-2-(aminoethyl)-3-aminopropyltriethoxysilane, 3-aminopropyltrimethoxysilane, 3-aminopropyltriethoxysilane, N-phenyl-3-aminopropyltrimethoxysilane, 3-mercaptopropylmethyldimethoxysilane, 3-mercaptopropyltrimethoxysilane, bis(triethoxypropyl)tetrasulfide, and 3-isocyanatepropyltriethoxysilane, and these may be used alone or in mixture of two or more.

By incorporating a silane coupling agent into a thermally decomposable resin composition, it becomes possible to improve an adhesion property between a supporting base and the compound semiconductor layer.

The diluting agent is not particularly limited, but examples thereof include cycloether compounds such as cyclohexene oxide and α-pinene oxide, aromatic cycloethers such as [methylene bis(4,1-phenylene oxymethylene)]bisoxirane, cyclo aliphatic vinyl ether compounds such as 1,4-cyclo hexane dimethanol divinyl ether.

When the thermally decomposable resin composition contains the diluting agent, flowability of the thermally decomposable resin composition may be improved, and thus wettability of the thermally decomposable resin composition with respect to the supporting base or the compound semiconductor layer may be improved.

(F-1) Next, as shown in FIG. (4-b), a surface of the compound semiconductor layer 1 at a side at which the n-type semiconductor layer 10 is formed and a surface at a side at which the thermally decomposable fixing resin layer 90 on the supporting base 80 is formed are made to face each other so as to adhere the compound semiconductor layer 1 onto the thermally decomposable fixing resin layer 90.

As a method of adhering the compound semiconductor layer 1 onto the thermally decomposable fixing resin layer 90 is not particularly limited, and this adhesion may be performed by using a vacuum press device or a semiconductor wafer bonding device, but it is preferable to use the semiconductor wafer bonding device that is capable of easily controlling a pressurization temperature and a pressurization load.

A condition of adhering the compound semiconductor layer 1 onto the thermally decomposable fixing resin layer 90 using the semiconductor wafer bonding device is not particularly limited, but the pressurization temperature is preferably 50 to 400°C, and more preferably 100 to 300°C. Furthermore, the pressurization load is not particularly limited, but 0.01 to 30 MPa is preferable, and more preferably 0.1 to 10 MPa. When the pressurization temperature and the pressurization weighting are set to the above-described range, reliable fixing of the compound semiconductor layer 1 to the thermally decomposable fixing resin layer 90 and prevention of breakage of the compound semiconductor layer 1 may be compatible with each other.

### Fourth Process

(G-1) Next, as shown in FIG. (4-c), a surface of the growth substrate 60, which is opposite to a surface on which the compound semiconductor layer 1 is formed, is irradiated with laser light.

The above-described laser light transmits through the growth substrate 60 and an interface between the growth substrate 60 and the compound semiconductor layer 1 is irradiated with the laser light. When the interface between the growth substrate 60 and the compound semiconductor layer 1 is irradiated with the laser light, thermal stress occurs at the interface between the growth substrate 60 and the compound semiconductor layer 1 due to a difference in a thermal expansion coefficient between the growth substrate 60 and the compound semiconductor layer 1, and thus the growth substrate 60 may be peeled-off from the compound semiconductor layer 1.

In addition, when the irradiation of the laser light is performed, a shock wave propagates to the thermally decomposable fixing resin layer 90 through the compound semiconductor 1, but since the thermally decomposable sacrificial material 90 relating to the present invention has a high adhesive property with respect to the compound semiconductor layer 1 and is excellent in stress relaxing property, the fixing resin layer 90 may reliably fix the compound semiconductor layer 1.

The above-described laser light is not particularly limited, but an excimer laser is preferable. Specifically, as an oscillation wavelength, ArF (193 nm), KrF (248 nm), XeCl (308 nm), XeF (353 nm), and the like may be mentioned, but KrF (248 nm) is more preferable.

(H-1) Next, as shown in FIG. (4-d), the growth substrate 60 is peeled off from the compound semiconductor layer 1.

In addition, the method of manufacturing the light-emitting element according to the present invention may include a process of roughening a surface of the n-type semiconductor layer 10 after peeling off the growth substrate 60 from the compound semiconductor layer 1. When the surface of the n-type semiconductor layer 10 is flat, light emitted from the light-emitting layer 30 is reflected on the surface of the n-type semiconductor layer 10 and thus light taking-out efficiency from the surface of the n-type semiconductor layer 10 is decreased, but when the surface of the n-type semiconductor layer 10 is roughened, reflection of light emitted from the light-emitting layer 30 may be effectively suppressed.

A method of roughening of the surface of the n-type semiconductor layer 10 is not particularly limited, but may be performed in a chemical manner or in a mechanical manner. Specifically, the roughening may be performed by dipping the surface of the n-type semiconductor layer 10 in potassium hydroxide solution.

In addition, unevenness of the roughened surface is not particularly limited, but unevenness having a magnitude of 1/4 to 1/2 times a wavelength of light emitted from the light-emitting layer 30 is preferable. When the unevenness of the roughened surface is set to the above-described range, the reflection of light emitted from the light-emitting layer 30 may be effectively suppressed.

### Fifth Process

(J-1) Next, as shown in FIG. (5-a), the thermally decomposable fixing resin layer 90 is heated so as to thermally decompose the thermally decomposable fixing resin layer 90.

When being heated, the thermally decomposable resin composition making up the thermally decomposable fixing resin layer 90 relating to the present invention is gasified and is vaporized, and thus a residue of the thermally decomposable resin composition may be difficult to occur on the compound semiconductor layer 1 and the supporting base 80 when the compound semiconductor layer 1 is peeled off from the supporting base 80. In addition, even when residue of the thermally decomposable resin composition occurs, the residue may be easily removed by being washed with a solvent or the like. Due to these effects, the thermally decomposable fixing resin layer 90 that is attached to the compound semiconductor layer 1 may be reliably removed, and thus a light-emitting element with high reliability may be manufactured. In addition, the thermally decomposable fixing resin layer 90 that is attached to the supporting base 80 may be reliably removed, and thus the supporting base 80 may be reused.

A temperature of heating the thermally decomposable fixing resin layer 90 is not particularly limited, but 50 to 500°C is preferable, and 100 to 350°C is more preferable. When the heating temperature is set to the above-described range, the compound semiconductor layer 1 may be reliably fixed during manufacturing the light-emitting element, and thermal deterioration or bending of the compound semiconductor layer 1 may be suppressed.

(K-1) Next, as shown in FIG. (5-b), the compound semiconductor layer 1 is peeled off from the supporting base 80, and a light-emitting element assembly 110 is obtained.

A method of peeling off the light-emitting element assembly 110 from the supporting base 80 is not particularly limited, but examples thereof include a method of peeling off the light-emitting element assembly 110 in a direction perpendicular to the surface of the supporting base 80, a method of sliding the light-emitting element assembly 110 in a horizontal direction with respect to the surface of the supporting base 80 so as to peel it off, and a method of floating the light-emitting element assembly 110 from one side of the light-emitting element assembly 110 and peeling it off.

The thermally decomposable fixing resin layer 90 relating to the present invention is hard to leave a residue on the compound semiconductor layer 1 and the supporting base 60 as described above, and thus the thermally decomposable fixing resin layer 90 may be peeled off without applying stress to the light-emitting element assembly 110. Therefore, breakage of the light-emitting element assembly 110 may be effectively suppressed, and thus the yield of the light-emitting element may be improved.

### Sixth Process

(L-1) Next, the light-emitting element assembly 110 is divided for each light-emitting element unit.

A method of dividing the light-emitting element assembly 110 for each light-emitting element unit is not particularly limited, but a known method of obtaining a semiconductor chip by dicing a semiconductor wafer into individual pieces may be used. Specifically, a light-emitting element 100 as shown in FIG. (5-d) may be obtained by adhering a dicing tape on the light-emitting element assembly 110 and dividing the light-emitting element 110 (dividing the light-emitting element 110 into individual pieces) using a dicing saw.

Next, an operation effect of the method of manufacturing the light-emitting element of the present invention will be described.

The method of manufacturing a light-emitting element according to the present invention includes: a first process of forming a compound semiconductor layer including semiconductor layers and a light-emitting layer on a growth substrate; a second process of forming an electrode on the compound semiconductor layer; a third process of adhering a thermally decomposable fixing resin layer of a thermally decomposable fixing resin layer-attached supporting base in which the thermally decomposable fixing resin layer is formed on the supporting base, and the compound semiconductor layer; a fourth process of irradiating a surface of the growth substrate, which is opposite to a surface on which the compound semiconductor layer is formed, with laser light so as to peel off the growth substrate and the compound semiconductor layer from each other; a fifth process of peeling off the compound semiconductor layer from the supporting base; and a sixth process of dividing the compound semiconductor layer into individual pieces, wherein in the fifth process, the compound semiconductor layer is peeled off from the supporting base by thermally decomposing the thermally decomposable fixing resin layer. Therefore, residue from the fixing resin layer is less likely to be left on the compound semiconductor layer and thus reliability of a light-emitting element that is obtained may be increased.

In addition, in the method of manufacturing the light-emitting element according to the present invention, a temperature to thermally decompose the thermally decomposable fixing resin layer is 50 to 500°C, and thus the thermally decomposable fixing resin layer is thermally decomposed in a reliable manner in the fifth process. As a result, prevention of thermal deterioration of the compound semiconductor layer and prevention of a bending state may be compatible with each other.

In addition, in the method of manufacturing the light-emitting element according to the present invention, as the thermally decomposable fixing resin layer, at least one kind of thermally decomposable resin component selected from a group consisting of a polycarbonate-based resin, a polyester-based resin, a polyamide-based resin, a polyimide-based resin, a polyether-based resin, a polyurethane-based resin, and a norbomene-based resin is contained. Therefore, residue from the fixing resin layer is less likely to be left and thus reliability of the light-emitting element that is obtained may be increased.

In addition, in the method of manufacturing the light-emitting element according to the present invention, as the fixing resin layer, at least one kind of thermally decomposable resin component selected from a group consisting of a polycarbonate-based resin, a polyester-based resin, a polyamide-based resin, a polyimide-based resin, a polyether-based resin, a polyurethane-based resin, and a norbomene-based resin, and a photoacid generator are contained. Therefore, the thermal decomposition temperature may be lowered, and thus the fixing resin layer is thermally decomposed in a reliable manner in the fifth process. As a result, prevention of thermal deterioration and prevention of a bending state of the compound semiconductor layer may be compatible with each other in a relatively effective manner.

In addition, the present invention is not limited to the above-described embodiment, and modification, alteration, and the like in the scope capable of accomplishing the object of the invention is included in the present invention.

### Industrial Applicability

According to the present invention, it is possible to provide a method of manufacturing a light-emitting element, in which residue from a fixing resin layer is less likely to be left on a group III nitride semiconductor layer and a supporting base in the case of manufacturing the light-emitting element by a laser lift-off technique. Furthermore, according to the present invention, it is possible to provide a highly reliable light-emitting element. Therefore, the present invention is very useful in an industrial field.

## Claims

1. A method of manufacturing a light-emitting element, comprising:
a first process of forming a compound semiconductor layer including semiconductor layers and a light-emitting layer on a growth substrate;
a second process of forming an electrode on the compound semiconductor layer;
a third process of adhering a thermally decomposable fixing resin layer of a thermally decomposable fixing resin layer-attached supporting base in which the thermally decomposable fixing resin layer is formed on the supporting base, and the compound semiconductor layer;
a fourth process of irradiating a surface of the growth substrate, which is opposite to a surface on which the compound semiconductor layer is formed, with laser light so as to peel the growth substrate and the compound semiconductor layer away from each other;
a fifth process of thermally decomposing the thermally decomposable fixing resin layer so as to peel the compound semiconductor layer from the supporting base away; and
a sixth process of dividing the compound semiconductor layer into individual pieces.

2. The method of manufacturing a light-emitting element according to claim 1,
wherein the semiconductor layers are an n-type semiconductor layer and a p-type semiconductor layer.

3. The method of manufacturing a light-emitting element according to claim 1 or 2,
wherein the growth substrate is made of sapphire glass.

4. The method of manufacturing a light-emitting element according to any one of claims 1 to 3,
wherein a temperature to thermally decompose the thermally decomposable fixing resin layer in the fifth process is 50 to 500°C.

5. The method of manufacturing a light-emitting element according to any one of claims 1 to 4,
wherein the thermally decomposable fixing resin layer contains at least one thermally decomposable resin component selected from a group consisting of a polycarbonate-based resin, a polyester-based resin, a polyamide-based resin, a polyimide-based resin, a polyether-based resin, a polyurethane-based resin, and a norbomene-based resin.

6. The method of manufacturing a light-emitting element according to any one of claims 1 to 5,
wherein the thermally decomposable resin component is a polycarbonate-based resin.

7. The method of manufacturing a light-emitting element according to any one of claims 1 to 6,
wherein the thermally decomposable fixing resin layer contains a photoacid generator.

8. The method of manufacturing a light-emitting element according to any one of claims 5 to 7,
wherein the polycarbonate-based resin includes at least one kind of structure unit selected from a group consisting of propylene carbonate, cyclohexylene carbonate, butylene carbonate, and norbomane carbonate.

9. A light-emitting element manufactured by the method according to any one of claims 1 to 8.
